# EUROPEAN PATENT SPECIFICATION

(11) **EP 2 782 271 B1**
(45) Date of publication and mention of the grant of the patent: **11.05.2022**
(21) Application number: 12850158.2
(22) Date of filing: 22.10.2012
(51) Int. Cl.: H04B 17/309, H04B 17/00, G01R 23/16

(54) **VECTOR SIGNAL ANALYZER**
VEKTORSIGNALANALYSATOR
ANALYSEUR DE SIGNAL VECTORIEL

(30) Priority: 17.11.2011 CN 201110366872
(43) Date of publication of application: 24.09.2014
(73) Proprietor: Datang Mobile Communications Equipment Co., Ltd., Beijing 100083 (CN)
(72) Inventor: DUAN, Tao, Beijing 100083 (CN); LEI, Xiaoyu, Beijing 100083 (CN); WANG, Hongwei, Beijing 100083 (CN)
(74) Representative: Nony
(86) International application number: PCT/CN2012/083326
(87) International publication number: WO 2013/071810

(56) References cited:
- EP-A1- 2 336 791
- CN-A- 1 869 716
- CN-A- 102 412 916
- DE-A1-102009 013 617
- JP-A- H1 151 990
- JP-A- 2004 104 277
- US-A- 5 731 699
- US-A1- 2005 021 261
- US-A1- 2009 082 982
- US-A1- 2009 082 982
- SIVULA A ED - INSTITUTE OF ELECTRICAL AND ELECTRONICS ENGINEERS: "Next-generation devices and networks bring opportunities and challenges", PROCEEDINGS INTERNATIONAL TEST CONFERENCE 2003. ( ITC ). CHARLOTTE, NC, SEPT. 30 - OCT. 2, 2003; [INTERNATIONAL TEST CONFERENCE], NEW YORK, NY : IEEE, US, vol. 1, 30 September 2003 (2003-09-30), pages 1319-1319, XP010685369, DOI: 10.1109/TEST.2003.1271159 ISBN: 978-0-7803-8106-3
- None

## Description

This application claims the benefit of Chinese Patent Application No. 201110366872.6, filed with the State Intellectual Property Office of People's Republic of China on November 17, 2011 and entitled "Vector signal analyzer".

### Field

The present invention relates to the field of communications and particularly to a vector signal analyzer.

### Background

At present, a vector signal analyzer configured to analyze a signal is generally provided with both a spectrum analysis function and a signal demodulation and analysis function, but since the vector signal analyzer is generally provided with only one receiver, only the spectrum analysis function or the signal demodulation and analysis function can be performed at a time, and in the case that both a spectrum condition in a specified frequency band needs to be observed, and the quality of a signal needs to be observed (i.e., the signal needs to be demodulated and analyzed), two instruments have to be used, which are a spectrum analyzer and a vector signal analyzer, or two vector signal analyzers provided with the spectrum analysis function, together with numerous auxiliary devices to build a test environment, thus resulting in much inconvenience and a high cost.

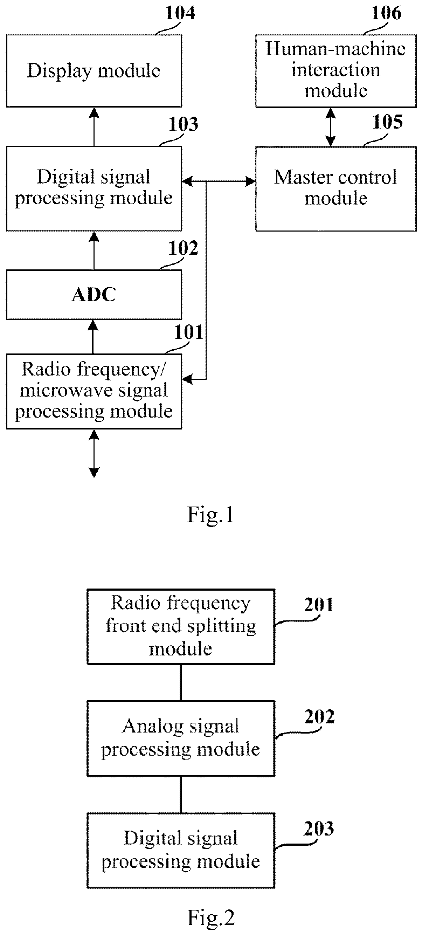

Specifically, as illustrated in Fig. 1, the vector signal analyzer generally includes a radio frequency/microwave signal processing module 101, an Analog-to-Digital Converter (ADC) 102 configured to convert an analog signal into a digital signal, a digital signal processing module 103, a display module 104, a master control module 105 and a human-machine interaction module 106.

The radio frequency/microwave signal processing module 101 is configured to down-convert a radio frequency/microwave signal for several times into a frequency of possible sampling by the ADC 102, where the frequency of possible sampling in the vector signal analyzer typically ranges from the order of k Hz to the order of G Hz;
The ADC 102 is configured to sample the down-converted analog signal for analog-to-digital conversion;
The digital signal processing module 103 is configured to analyze data output by the ADC 102;
The display module 104 is configured to translate the data into a graphic curve and to display the graphic curve on a display screen of the vector signal analyzer;
The human-machine interaction module 106 is configured to receive operations on the instrument by an operator via a menu on a panel and to translate these operations into control commands; and
The master control module 105 is configured to set parameters and control processes on respective functional circuits of the instrument in response to the control commands to perform tests and data processing as desirable to the operator.

Moreover a clock and a power source are two hardware components required in the instrument primary for the purpose of providing clocks and power supply to the circuits inside the instrument.

Since there is only one receiver in the existing vector signal analyzer, the spectrum measurement function and the signal demodulation and analysis function have to be switched on sequentially for operation and measurement instead of concurrent measurement and display.

JP H1151990 A1 discloses an input signal is partitioned into two parts by a distributor 25, a frequency band component of a channel signal in a TDMA burst signal and a spurious frequency band component are selected by selection means 26, 27 respectively, the former is compressed by a log Amp 36 and detected, and, when it comes to a prescribed level or more, a trigger signal is generated by a trigger generating part 39. The signal from the means 27 is linearly amplified, then converted into a digital signal by AD convertion, and the trigger signal and its approximate portions are stored in a memory 47 as digital signals. The memory 47 is read out thereafter, and relation for frequency, time, electric power is found by FFT or the like in computer 53 to be displayed in a display 18. Other examples of prior art can be seen in US 2005/021261 A1 and US 2009/082982 A1.

### Summary

An embodiment of the invention provides a vector signal analyzer so as to perform a spectrum measurement function and a signal demodulation and analysis function concurrently.

A vector signal analyzer includes:
a radio frequency front end splitting module configured to split a received signal into at least two same signals;
an analog signal processing module configured to perform radio frequency/microwave processing and analog-to-digital conversion on each of the signals; and
a digital signal processing module configured to concurrently perform a spectrum analysis on the one of the digital signals output by the analog signal processing module and a signal demodulation and analysis on another of the digital signals output by the analog signal processing module;
where the analog signal processing module includes:
   at least two radio frequency/microwave signal processing sub-modules configured to perform radio frequency/microwave processing respectively on the respective signals; and
   ADC sub-modules, the number of which is the same as the number of radio frequency/microwave signal processing sub-modules, configured to perform analog-to-digital conversion respectively on signals output by the respective radio frequency/microwave signal processing sub-modules.

An embodiment of the invention provides a vector signal analyzer in which a received signal is split by a radio frequency front end splitting module into at least two signals, radio frequency/microwave processing and analog-to-digital conversion is performed on each of the signals, and a spectrum analysis or a signal demodulation and analysis is performed respectively by a digital signal processing module on the respective signals, thereby performing a spectrum measurement function and a signal demodulation and analysis function concurrently. At least two same signals splitting from a signal instead of a plurality of signals acquired respectively are analyzed, and the same clock source is used for respective modules inside the same instrument, thereby achieving better synchronization between respective analysis results and facilitating a comparison between and an analysis of them by a human operator.

### Brief Description of the Drawings

Fig. 1 is a schematic structural diagram of a vector signal analyzer in the prior art;
Fig. 2 is a schematic structural diagram of a vector signal analyzer according to an embodiment of the invention; and
Fig. 3 is a schematic structural diagram of a preferred vector signal analyzer according to an embodiment of the invention.

### Detailed Description

An embodiment of the invention provides a vector signal analyzer in which a received signal is split by a radio frequency front end splitting module into at least two signals, and radio frequency/microwave processing and analog-to-digital conversion is performed on each of the signals, and then a spectrum analysis or a signal demodulation and analysis is performed by a digital signal processing module respectively on the respective signals, thereby performing a spectrum measurement function and a signal demodulation and analysis function concurrently.

As illustrated in Fig. 2, a vector signal analyzer according to an embodiment of the invention includes:
a radio frequency front end splitting module 201 configured to split a received signal into at least two same signals;
an analog signal processing module 202 configured to perform radio frequency/microwave processing and analog-to-digital conversion on each of the signals; and
a digital signal processing module 203 configured to perform a spectrum analysis or a signal demodulation and analysis respectively on respective digital signals output by the analog signal processing module 202.

A received signal is split into at least two same signals, and a spectrum analysis or a signal demodulation and analysis is performed respectively on the respective signals as a result of splitting, thereby enabling a vector signal analyzer to perform a spectrum analysis function and a signal demodulation and analysis function concurrently. Moreover at least two same signals splitting from a signal instead of a plurality of signals acquired respectively are analyzed, and the same clock source is used for the respective modules inside the same instrument, thereby achieving better synchronization between respective analysis results and facilitating a comparison between and an analysis of them by a human operator.

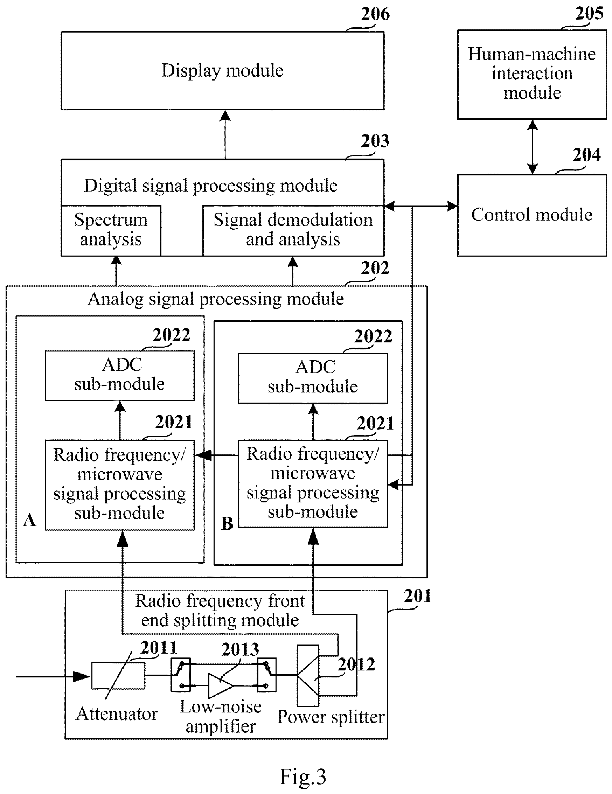

A preferred vector signal analyzer according to an embodiment of the invention will be described below with reference to Fig. 3, where in the vector signal analyzer, the radio frequency front end splitting module 201 includes:
an attenuator 2011 configured to attenuate an input signal; and
a power splitter 2012 configured to split the attenuated signal and to output at least two same signals.

Particularly the attenuator 2011 can be embodied as a remotely controllable variable attenuator configured to adjust an attenuation amount according to the level of the received signal and other conditions in practice and perform appropriate attenuation, where a process of adjusting the attenuation amount can be performed manually by the human operator or automatically by the vector signal analyzer according to the level of the signal.

When the input signal is at a low level, the signal can be adjusted by a low noise amplifier into a preset range for a better analysis of the signal, and thus the radio frequency front end splitting module 201 may include:
an attenuator 2011 configured to attenuate the input signal;
a low noise amplifier 2013, arranged between the attenuator 2011 and a power splitter 2012, configured to amplify the attenuated signal; and
the power splitter 2012 configured to split the signal attenuated by the attenuator 2011 and amplified by the low noise amplifier 2013 and to output at least two same signals.

In order to avoid the level of a signal from becoming too high after any signal is low-noise-amplified, whether to amplify the received signal can be decided by two sets of single-pole-double-throw switches, and as illustrated in Fig. 3, the attenuator 2011 is connected with two branches through the single-pole-double-throw switches with the low noise amplifier 2013 arranged on one of the branches and without any amplification device arranged on the other branch, and after the signal is attenuated by the attenuator 2011, the signal can be decided according to the level of the signal to pass the branch with the low noise amplifier 2013 or the branch without the low noise amplifier 2013.

These two sets of single-pole-double-throw switches can be controlled by the human operator or automatically by the vector signal analyzer.

As can be apparent from Fig. 3, the analog signal processing module 202 includes:
at least two radio frequency/microwave signal processing sub-modules 2021 configured to perform radio frequency/microwave processing respectively on the respective signals; and
ADC sub-modules 2022, the number of which is the same as the number of radio frequency/microwave signal processing sub-modules 2021, configured to perform analog-to-digital conversion respectively on the signals output by the respective radio frequency/microwave signal processing sub-modules 2021.

Typically in order to analyze the corresponding number of signals, the number of radio frequency/microwave signal processing sub-modules 2021 and the number of ADC sub-modules 2022 in the analog signal processing module 202 shall not be below the number of signals as a result of splitting by the power splitter 2012.

In order to control parameters of the respective modules including the radio frequency front end splitting module 201 and the analog signal processing module 202, as illustrated in Fig. 3, the vector signal analyzer further includes:
a control module 204 configured to set parameters and control processes of the digital signal processing module 203 and the analog signal processing module 202 in response to received control commands.

In order to facilitate setting the parameters of the respective modules by the human operator, the vector signal analyzer further includes:
a human-machine interaction module 205 configured to receive operations by the operator via a menu on a panel and to translate the operations into the control commands transmitted to the control module 204.

In order to facilitate observation of an analysis result by the operator, the vector signal analyzer further includes:
a display module 206 configured to translate data into a graphic curve according to an analysis result of the digital signal processing module 203 and to display the graphic curve on a display screen.

Since the vector signal analyzer can analyze a plurality of signals concurrently, in order to facilitate better observation by the operator of analysis results of the signals in respective frequency bands, curves corresponding to the respective analysis results can be displayed concurrently on the display screen to thereby facilitate a comparison between and observation of them by the operator, and thus the display module 206 is further configured:
to translate data into graphic curves according to respective analysis results of the digital signal processing module 203 and to display the graphic curves on the display screen.

The display screen can be a computer screen or can be another display device that can be connected with the vector signal analyzer.

Typically for an analysis of a signal, the received signal at a preset frequency is demodulated and analyzed, while spectrums of the signal in other significant frequency bands are analyzed, so that one signal into which the signal is split can be demodulated and analyzed at the preset frequency while the spectrums of the other signal(s) in the radio frequency bands are analyzed, and thus the digital signal processing module 203 is configured:
to demodulate and analyze one digital signal output by the analog signal processing module 202 and to analyze spectrums of the other signal(s) output by the analog signal processing module 202.

Since a spectrum can be analyzed by adjusting a frequency band for the analysis, the signal can be split into only two signals in practice, so that one of the signals can be demodulated and analyzed while a spectrum of the other signal can be analyzed, where the signal is demodulated and analyzed typically at a preset fixed frequency which is changed infrequently, and the spectrum of the signal is analyzed in a specific frequency band, and the frequency band for the analysis can be changed by the operator at any time to thereby observe an analysis result in the corresponding frequency band. Stated otherwise, the analog signal processing module 202 can convert the signal in the spectrum analysis function by specifying freely the frequency band for the analysis, and the analog signal processing module 202 can convert the signal in the signal demodulation and analysis function typically at a fixed frequency for the signal demodulation and analysis, so the signal demodulation and analysis and the spectrum analysis can be performed concurrently on these two signals by the analog signal processing module and the digital signal processing module of a receiver with two channels.

It shall be noted that the respective microwave/radio frequency processing modules perform gain control, frequency conversion and filtering on the same input signal at corresponding frequencies or in corresponding frequency bands and then typically output respective different analog immediate-frequency signals to the ADCs, which in turn perform analog-to-digital conversion thereon and output digital signals at corresponding frequencies or in corresponding frequency bands for a corresponding signal demodulation and analysis or spectrum analysis by the digital signal processing module.

An embodiment of the invention provides a vector signal analyzer in which a received signal is split by a radio frequency front end splitting module into at least two signals, and radio frequency/microwave processing and analog-to-digital conversion is performed on each of the signals, and then a spectrum analysis or a signal demodulation and analysis is performed by a digital signal processing module respectively on the respective signals, thereby performing a spectrum measurement function and a signal demodulation and analysis function concurrently.

## Claims

1. A vector signal analyzer, comprising:
a radio frequency front end splitting module (201) configured to split a received signal into at least two same signals;
an analog signal processing module (202) configured to perform radio frequency/microwave processing and analog-to-digital conversion on each of the signals; and
a digital signal processing module (203) configured to concurrently perform a spectrum analysis on the one of the digital signals output by the analog signal processing module (202) and a signal demodulation and analysis on another of the digital signals output by the analog signal processing module (202);
wherein the analog signal processing module (202) comprises:
at least two radio frequency/microwave signal processing sub-modules (2021) configured to perform radio frequency/microwave processing respectively on the respective signals; and
ADC sub-modules (2022), the number of which is the same as the number of radio frequency/microwave signal processing sub-modules (2021), configured to perform analog-to-digital conversion respectively on signals output by the respective radio frequency/microwave signal processing sub-modules (2021).

2. The vector signal analyzer of claim 1, wherein the radio frequency front end splitting module (201) comprises:
an attenuator configured to attenuate an input signal; and
a power splitter configured to split attenuated signal and to output at least two same signals.

3. The vector signal analyzer of claim 1, wherein the radio frequency front end splitting module (201) comprises:
an attenuator configured to attenuate an input signal;
a low noise amplifier configured to amplify attenuated signal; and
a power splitter configured to split a signal amplified by the low noise amplifier and to output at least two same signals.

4. The vector signal analyzer of claim 1, further comprising:
a control module (204) configured to set parameters and control processes of the digital signal processing module (203) and the analog signal processing module (202) in response to received control commands.

5. The vector signal analyzer of claim 4, further comprising:
a human-machine interaction module (205) configured to receive operations by an operator via a menu on a panel and to translate the operations into the control commands transmitted to the control module (204).

6. The vector signal analyzer of claim 1, wherein the digital signal processing module (203) is configured:
to demodulate and analyze one of the digital signals output by the analog signal processing module (202) and to analyze spectrums of the other signals output by the analog signal processing module (202).

7. The vector signal analyzer of claim 1, further comprising:
a display module (206) configured to translate data into a graphic curve according to an analysis result of the digital signal processing module (203) and to display the graphic curve on a display screen.

8. The vector signal analyzer of claim 7, wherein the display module (206) is configured:
to translate data into graphic curves according to respective analysis results of the digital signal processing module (203) and to display the graphic curves on the display screen.

## Patentansprüche

1. Vektorsignalanalysator, umfassend:
ein Hochfrequenz-Frontend-Teilermodul (201), das zum Teilen eines Empfangssignals in mindestens zwei gleiche Signale konfiguriert ist;
ein Analogsignalverarbeitungsmodul (202), das zum Durchführen von Hochfrequenz-/Mikrowellenverarbeitung und Analog-Digital-Umwandlung an jedem der Signale konfiguriert ist; und
ein Digitalsignalverarbeitungsmodul (203), das so konfiguriert ist, dass es gleichzeitig eine Spektralanalyse an dem einen der digitalen Signale, die vom Analogsignalverarbeitungsmodul (202) ausgegeben werden, und eine Signaldemodulation und -analyse am anderen der digitalen Signale durchführt, die vom Analogsignalverarbeitungsmodul (202) ausgegeben werden,
wobei das Analogsignalverarbeitungsmodul (202) umfasst:
mindestens zwei Hochfrequenz-/Mikrowellen-Signalverarbeitungssubmodule (2021), die jeweils zum Durchführen von Hochfrequenz-/Mikrowellenverarbeitung an den jeweiligen Signalen konfiguriert sind; und
ADC-Submodule (2022), deren Anzahl gleich der Anzahl von Hochfrequenz-/Mikrowellen-Signalverarbeitungssubmodulen (2021) ist und die jeweils zum Durchführen von Analog-Digital-Umwandlung an Signalen konfiguriert sind, die von den jeweiligen Hochfrequenz-/Mikrowellen-Signalverarbeitungssubmodulen (2021) ausgegeben werden.

2. Vektorsignalanalysator nach Anspruch 1, wobei das Hochfrequenz-Frontend-Teilermodul (201) umfasst:
ein Dämpfungsglied, das zum Dämpfen eines Eingangssignals konfiguriert ist; und
einen Leistungsteiler, der zum Teilen des gedämpften Signals und zum Ausgeben mindestens zweier gleicher Signale konfiguriert ist.

3. Vektorsignalanalysator nach Anspruch 1, wobei das Hochfrequenz-Frontend-Teilermodul (201) umfasst:
ein Dämpfungsglied, das zum Dämpfen eines Eingangssignals konfiguriert ist; und
einen rauscharmen Verstärker, der zum Verstärken des gedämpften Signals konfiguriert ist;
einen Leistungsteiler, der zum Teilen eines vom rauscharmen Verstärker verstärkten Signals und zum Ausgeben mindestens zweier gleicher Signale konfiguriert ist.

4. Vektorsignalanalysator nach Anspruch 1, ferner umfassend:
ein Steuermodul (204), das zum Festlegen von Parametern und Steuerprozessen des Digitalsignalverarbeitungsmoduls (203) und des Analogsignalverarbeitungsmoduls (202) in Reaktion auf empfangene Steuerbefehle konfiguriert ist.

5. Vektorsignalanalysator nach Anspruch 4, ferner umfassend:
ein Mensch-Maschine-Interaktionsmodul (205), das so konfiguriert ist, dass es Operationen durch einen Bediener über ein Menü auf einem Bildschirm empfängt und die Operationen in die Steuerbefehle übersetzt, die an das Steuermodul (204) gesendet werden.

6. Vektorsignalanalysator nach Anspruch 1, wobei das Digitalsignalverarbeitungsmodul (203) konfiguriert ist zum:
Demodulieren und Analysieren eines der digitalen Signale, die vom Analogsignalverarbeitungsmodul (202) ausgeben werden, und Analysieren von Spektren der anderen Signale, die vom Analogsignalverarbeitungsmodul (202) ausgegeben werden.

7. Vektorsignalanalysator nach Anspruch 1, ferner umfassend:
ein Anzeigemodul (206), das so konfiguriert ist, dass es Daten in eine grafische Kurve gemäß einem Analyseergebnis der Digitalsignalverarbeitungsmodul (203) übersetzt und die grafische Kurve auf einem Anzeigebildschirm anzeigt.

8. Vektorsignalanalysator nach Anspruch 7, wobei das Anzeigemodul (206) konfiguriert ist zum:
Übersetzen von Daten in grafische Kurven gemäß jeweiligen Analyseergebnissen des Digitalsignalverarbeitungsmoduls (203) und Anzeigen der grafischen Kurven auf einem Anzeigebildschirm.

## Revendications

1. Analyseur de signaux vectoriels comprenant :
un module de division d'entrée de radiofréquence (201) configuré pour diviser un signal reçu en au moins deux signaux identiques ;
un module de traitement de signaux analogiques (202) configuré pour effectuer un traitement radiofréquence/hyperfréquence et une conversion analogique-numérique sur chacun des signaux ; et
un module de traitement de signaux numériques (203) configuré pour effectuer simultanément une analyse de spectre sur l'un des signaux numériques délivré en sortie par le module de traitement de signaux analogiques (202) et une démodulation et une analyse de signaux sur un autre des signaux numériques émis par le module de traitement de signaux analogiques (202) ;
où le module de traitement de signaux analogiques (202) comprend :
au moins deux sous-modules de traitement de signaux radiofréquence/hyperfréquence (2021) configurés pour effectuer un traitement radiofréquence/hyperfréquence, respectivement, sur les signaux respectifs ; et
des sous-modules ADC (2022), dont le nombre est le même que le nombre de sous-modules de traitement de signaux radiofréquence/hyperfréquence (2021), configurés pour effectuer une conversion analogique-numérique respectivement sur les signaux délivrés en sortie par les sous-modules de traitement de signaux radiofréquence/hyperfréquence respectifs (2021).

2. Analyseur de signaux vectoriels selon la revendication 1, dans lequel le module de division d'entrée radiofréquence (201) comprend :
un atténuateur configuré pour atténuer un signal d'entrée ; et
un diviseur de puissance configuré pour diviser le signal atténué et pour délivrer en sortie au moins deux signaux identiques.

3. Analyseur de signaux vectoriels selon la revendication 1, dans lequel le module de division d'entrée radiofréquence (201) comprend :
un atténuateur configuré pour atténuer un signal d'entrée ;
un amplificateur à faible bruit configuré pour amplifier le signal atténué ; et
un diviseur de puissance configuré pour diviser un signal amplifié par l'amplificateur à faible bruit et pour délivrer en sortie au moins deux signaux identiques.

4. Analyseur de signaux vectoriels selon la revendication 1, comprenant en outre :
un module de contrôle (204) configuré pour définir des paramètres et contrôler des processus du module de traitement de signaux numériques (203) et du module de traitement de signaux analogiques (202) en réponse à des commandes de contrôle reçues.

5. Analyseur de signaux vectoriels selon la revendication 4, comprenant en outre :
un module d'interaction homme-machine (205) configuré pour recevoir des opérations par un opérateur par l'intermédiaire d'un menu sur un panneau et pour traduire les opérations en commandes de contrôle transmises au module de contrôle (204).

6. Analyseur de signaux vectoriels selon la revendication 1, dans lequel le module de traitement de signaux numériques (203) est configuré :
pour démoduler et analyser l'un des signaux numériques délivré en sortie par le module de traitement de signaux analogiques (202) et pour analyser les spectres des autres signaux délivrés en sortie par le module de traitement de signaux analogiques (202).

7. Analyseur de signaux vectoriels selon la revendication 1, comprenant en outre :
un module d'affichage (206) configuré pour traduire les données en une courbe graphique selon un résultat d'analyse du module de traitement de signaux numériques (203) et pour afficher la courbe graphique sur un écran d'affichage.

8. Analyseur de signaux vectoriels selon la revendication 7, dans lequel le module d'affichage (206) est configuré :
pour traduire des données en courbes graphiques selon des résultats d'analyse respectifs du module de traitement de signaux numériques (203) et pour afficher les courbes graphiques sur l'écran d'affichage.
